(19) Europäisches Patentamt
European Patent Office
Office européen des brevets

(11) EP 0 407 099 B1

(12) EUROPEAN PATENT SPECIFICATION

(45) Date of publication and mention of the grant of the patent:
**17.01.1996 Bulletin 1996/03**

(51) Int Cl.$^6$: **H01L 41/08**

(21) Application number: **90307104.1**

(22) Date of filing: **28.06.1990**

# (54) Multi-layered ceramic elements and method for producing same

Mehrschichtiges Keramik-Element und Methode zu dessen Herstellung

Elément céramique multi-couches et méthode de production de celui-ci

(84) Designated Contracting States:
**DE FR GB NL**

(30) Priority: **05.07.1989 JP 171854/89**
**15.11.1989 JP 294900/89**
**06.02.1990 JP 25264/90**

(43) Date of publication of application:
**09.01.1991 Bulletin 1991/02**

(73) Proprietor: **MITSUI TOATSU CHEMICALS, Inc.**
**Chiyoda-Ku, Tokyo 100 (JP)**

(72) Inventors:
- **Hagimura, Atsushi**
  **Kamakura-shi, Kanagawa (JP)**
- **Nishihara, Kunio**
  **Yokohama-shi, Kanagawa (JP)**
- **Nakajima, Mutsuo**
  **Suginami-ku, Tokyo (JP)**
- **Inage, Ikuo**
  **Yokohama-shi, Kanagawa (JP)**

(74) Representative:
**Rackham, Anthony Charles et al**
**London WC2R 0AE (GB)**

(56) References cited:
**EP-A- 0 167 392**

- **PATENT ABSTRACTS OF JAPAN, vol. 12, no. 30 (E-578), 28 January 1988 ; & JP-A-62 186 672**
- **PATENT ABSTRACTS OF JAPAN, vol. 11, no. 277 (E-538), 8 September 1987 ; & JP-A-62 076 913**
- **H.G. ELIAS et al.: "Neue Polymere Werkstoffe für die industrielle Anwendung", 2. Folge, 1983, Hansen, München, Section 11.2.1, pp. 257-262**
- **A. FRANCK et al.: "Kunststoff-Kompendium", 1984, Vogel-Buchverlag, Würzburg, Section 4.6.3, pp. 186-189**
- **PATENT ABSTRACTS OF JAPAN, vol. 13, no. 277 (E-778), 26 June 1989 ; & JP-A-01 065 819**
- **PATENT ABSTRACTS OF JAPAN, vol. 8, no. 235 (E-275), 27 October 1984 ; & JP-A-59 115 579**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).



Printed by Jouve, 75001 PARIS (FR)

## Description

The present invention relates to a multi-layered ceramic element and more specifically to a multi-layered ceramic condenser element and a multi-layered electrostrictive/piezoelectric ceramic element as well as to a method for producing these elements.

Up to now, multi-layered ceramic elements comprising ceramic films or thin plates and inner electrodes which are superimposed alternatively, for instance, multi-layered ceramic condenser elements and multi-layered electrostrictive/piezoelectric ceramic elements have usually been produced according to the following method. A starting composition is first mixed and calcined, then a proper binder and a solvent are mixed with the calcined powder and the resulting mixture is formed into a thin film or plate by a doctor blade technique. A metal electrode is printed on the thin film and a plurality of such thin films on which the metal electrodes are printed are arranged in layers. Every other metal electrode plate in the resulting multi-layered assembly is connected to one of two external electrodes, one of which serves as a positive electrode and the other of which serves as a negative electrode. In this production method, it is required to decrease the area of the overlap between the positive and negative electrodes as compared with the overall cross section of the multi-layered assembly as shown in Fig. 1, of the accompanying drawing which shows a shematic diagram of such a condender. This, however, leads to the exclusion of the overlap between the electrode plates at the periphery of the assembly as can clearly be seen from Figure 1. In Fig. 1, the reference numeral 1 represents a dielectric ceramic, 2 an inner electrode and 3 an external electrode.

The electrostatic capacity of a condenser is in general proportional to the area of the overlap between electrodes present in a multi-layered ceramic condenser. However, the entire cross section of the ceramic thin film cannot be used in the foregoing condenser. This becomes a major obstacle in obtaining a small-sized condenser having a high capacity. On the other hand, when an electric voltage is applied to a multi-layered electrostrictive/piezoelectric ceramic element, a relatively large displacement is generated at the overlap between electrode plates. As a result, strain centers in the vicinity of the boundary between the overlapped and non-overlapped portions of the electrodes. Thus, the ceramic is often broken and the inner electrode is sometimes damaged such as peeling off of the same if an electric voltage is applied to the element for a long period of time or a voltage is repeatedly applied thereto. Moreover, the precision for printing inner electrodes must be improved and highly precise alignment of green sheets must be enhanced when they are arranged in layers to produce such a multi-layered ceramic condenser element and a multi-layered electrostrictive/piezoelectric ceramic element. This is a major obstacle in improving the productivity thereof.

One method for eliminating the foregoing drawback has been proposed in Japanese Patent Unexamined Published Application (hereinafter referred to as "J.P. KOKAI") No. Sho 59-115579 which relates to an electrostriction effect element. The application discloses a method for producing an electrostriction effect element which comprises forming an inorganic insulating layer on all the areas of the electrodes exposed at the side end faces of the element or on such areas of every other electrode by making use of an electrophoresis technique. The foregoing drawback can be eliminated by using such a method, but this method is unfavorable in view of its cost because the inorganic insulating layer (in most cases, made of glass) must be baked at a high temperature. In addition, an inorganic insulating layer in general has good compatibility to ceramic bodies and adheres to the bodies over a wide area thereof. Thus, it is said that the distance between the layers of the multi-layered element must be 100 $\mu$ m or more so as to prevent the insulating layers applied onto the areas of the electrodes exposed at the side end faces of the element from being continuous. This means that this method cannot provide condensers having a high electrostatic capacity and a distance between electrodes of 100 $\mu$ m or less.

Recently, there has been an increasing demand for a small-sized condenser having a high electrostatic capacity. For this reason, many efforts have been directed to search for ceramics having a high dielectric constant and to reduce the thickness of each ceramic layer constituting a multi-layered cetramic condenser element. Thus, even elements in which the thickness of each layer is 10 $\mu$ m or less have already been made on an experimental basis. With regard to multi-layered electrostrictive/piezoelectric ceramic elements, there has recently been an increasing demand for such elements exhibiting a high quantity of displacement. In order to produce elements having such a high quantity of displacement, it is of great importance to reduce the thickness of each layer of the multi-layered electrostrictive/piezoelectric ceramic element as much as possible. When the distance between the layers of the multi-layered electrostrictive/piezoelectric ceramic element is 100 $\mu$ m or more, it is necessary to apply a high voltage of the order of 100V or more in order to apply an electric field of 10 kV/cm to the multi-layered electrostrictive/piezoelectric ceramic element. The driving voltage of such an element can be reduced by decreasing the distance between the layers constituting the same.

In order to produce multi-layered ceramic condensers and multi-layered electrostrictive/piezoelectric ceramic elements having such thin layers at a high efficiency, the development of a novel method for insulating electrodes which does not possess the drawbacks described above in connection with the method disclosed in J.P. KOKAI No. Sho 59-115579 has been desired.

According to the invention there is provided a method of producing a multi-layered ceramic element which comprises the steps of immersing a ceramic multi-layered body, which comprises a plurality of ceramic films or plates and a plurality

of inner electrodes which are alternatively arranged in layers with the ends of the inner electrodes being exposed at side end faces of the multi-layered body, in an electrophoresis bath for forming a deposit which is obtained by neutralizing, with a base, carboxyl groups of a polyamide acid resin having repeating units represented by the following general formula:

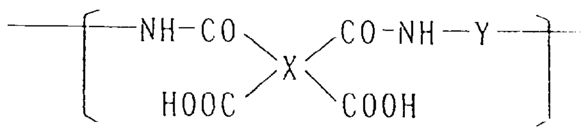

in which X represents a tetravalent phenyl group, a tetravalent biphenyl group or a tetravalent polyphenyl and polybiphenyl group in which at least one of either the phenyl group or biphenyl group is bonded through at least one of O, CO, S, $SO_2$, $CH_2$, $C(CH_3)_2$ and $C(CF_3)_2$, and Y represents a phenylene group, biphenylene group, a bivalent polyphenyl and polybiphenyl group in which at least one of either the phenyl group or biphenyl group is bonded through at least one of O, CO, S, $SO_2$, $CH_2$, $C(CH_3)_2$ and C(CF3)$_2$ an alkylene group or a xylylene group, and then diluting the resin with water, carrying out electrophoresis by passing an electric current through only alternate inner electrodes of the ceramic multi-layered body which serve as anodes to deposit the polyamide acid resin on only the exposed portions of the said alternate inner electrodes and the ceramic surface in the vicinity of the exposed portions of those electrodes and to thus form a deposit, heat-treating the resulting assembly at a temperature from 80 to 280°C to convert the polyamide acid resin into its imide form to thus form an insulating deposit comprising a polyimide resin represented by the following general formula:

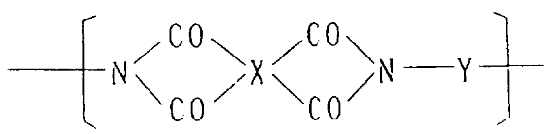

in which X and Y are as defined above, cutting the resulting assembly,
and subjecting the other of the said alternate inner electrodes to the electrophoresis and heat treating as defined above.

The multi-layered ceramic elements made according to the invention use a specific organic insulating material. In this way the present invention makes it possible to reduce the distance between the layers constituting such an element to 10 to 100 μ m, which in turn makes it possible to obtain a small-sized multi-layered ceramic condenser having a high capacity and further to obtain a multi-layered electrostrictive/piezo-electric ceramic element having a high quantity of displacement and capable of being driven at a low electric voltage.

In one embodiment of the invention the electrophoresis bath may contain the said polyamide acid resin and an insulating filler dispersed therein so that the insulating deposit comprises the said polyimide resin and the insulating filler.

The foregoing polyamide acid resin used in the method according to the present invention may be partially converted into its imide form in advance.

## BRIEF EXPLANATION OF THE DRAWINGS

Fig. 1 is a schematic diagram for illustrating a conventional multi-layered ceramic condenser presently available in the market;

Fig. 2 (a) is a schematic diagram for illustrating a multi-layered ceramic element according to the present invention; and

Fig. 2 (b) is a schematic diagram for illustrating a method for insulating a multi-layered ceramic element according to the present invention.

In the foregoing polyimide resins having repeating units represented by the general formula (I) and the polyamide acid resins having repeating units represented by the general formula (II), specific examples of X are as follows:

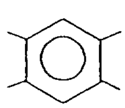 , 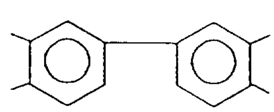 , 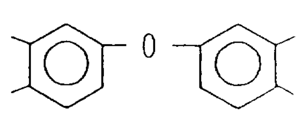 ,

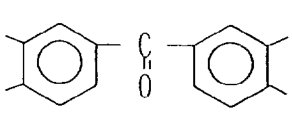 , 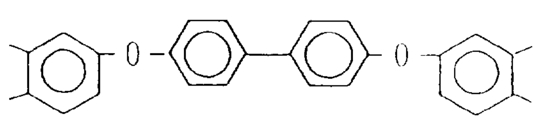 ,

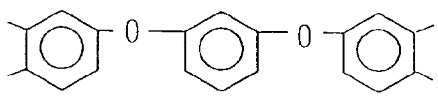,

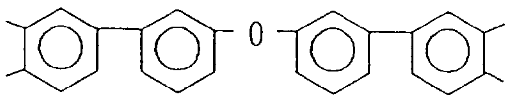,

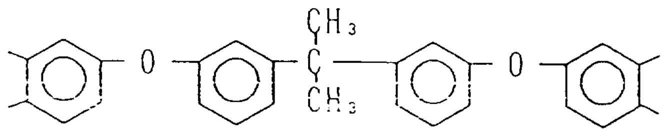,

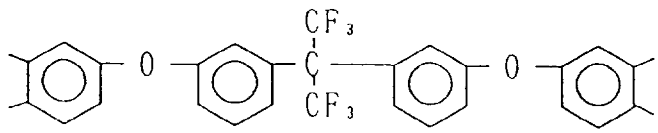,

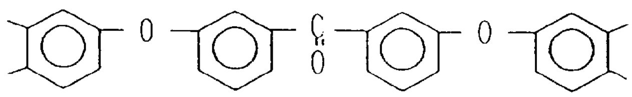,

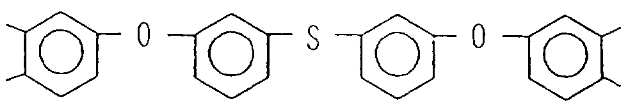,

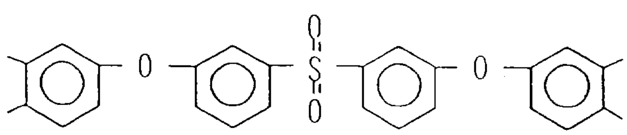.

On the other hand, specific examples of Y in the general formulae (I) and (II) are as follows:

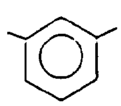, 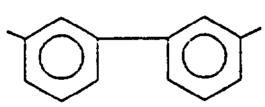, 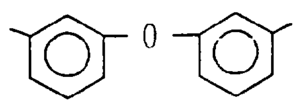,

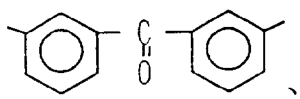, 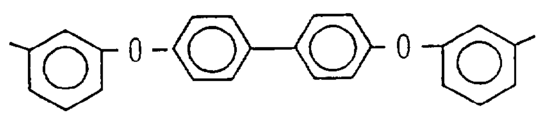,

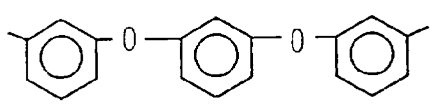,

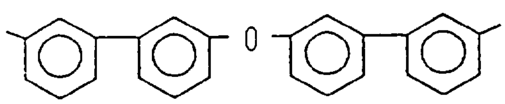,

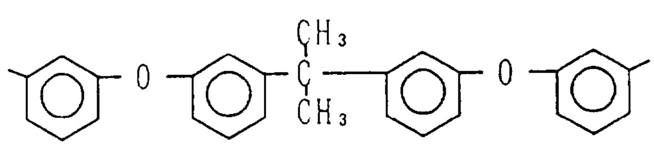,

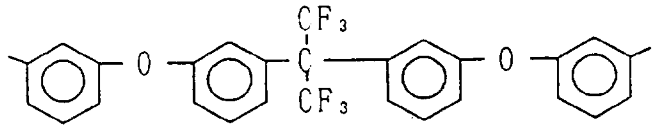,

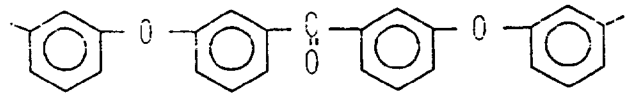,

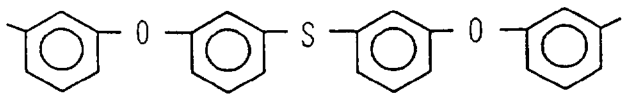,

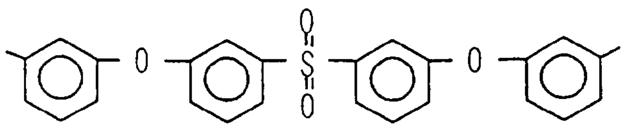.

If the adhesion and heat resistance of the polyimide resins having repeating units represented by the general formula (I) to the multi-layered ceramic substrates are taken into consideration, particularly preferred X's are as follows:

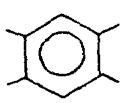, 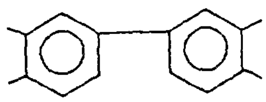, 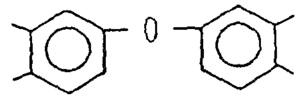

or

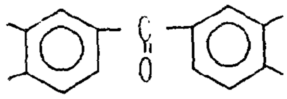

and particularly preferred Y's are as follows:

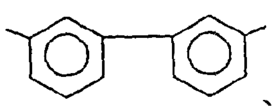, 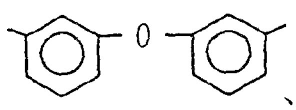,

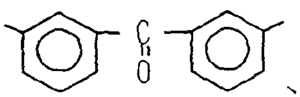, 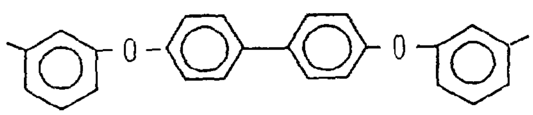,

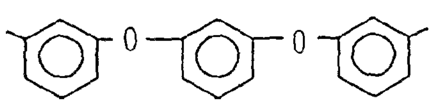

or

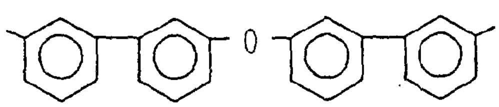.

The polyamide acid resins having repeating units represented by the general formula (II) used in the method of this invention can be obtained through an addition reaction of tetracarboxylic acid anhydrides represented by the following general formula (III):

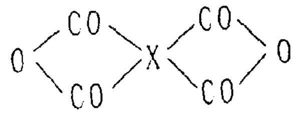

(III)

wherein X is the same as that defined above with diamines represented by the following general formula (IV):

$$H_2N - Y - NH_2 \qquad (IV)$$

wherein Y is the same as that defined above.

Preferred examples of the foregoing tetracarboxylic acid anhydrides are pyromellitic acid dianhydride, 3,3',4,4'-benzophenonetetracarboxylic acid dianhydride, 2,2',3,3'-benzophenonetetracarboxylic acid dianhydride, 3,3',4,4'-biphenyltetracarboxylic acid dianhydride, 2,2',3,3'-biphenyltetracarboxylic acid dianhydride, 2,2-bis(3,4-dicarboxyphenyl)propane dianhydride, 2,2-bis(2,3-dicarboxyphenyl)propane dianhydride, bis(3,4-dicarboxyphenyl) ether dianhydride, bis (3,4-dicarboxyphenyl) sulfone dianhydride, 1,1-bis(2,3-dicarboxyphenyl) ethane dianhydride, bis(2,3-dicarboxyphenyl) methane dianhydride, bis(3,4-dicarboxyphenyl) methane dianhydride, 2,3,6,7-naphthalenetetracarboxylic acid dianhydride, 1,4,5,8-naphthalenetetracarboxylic acid dianhydride, 1,2,5,6-naphthalenetetracarboxylic acid dianhydride, 1,2,3,4-benzenetetracarboxylic acid dianhydride, 3,4,9,10-perylenetetracarboxylic acid dianhydride, 2,3,6,7-anthracenetetracarboxylic acid dianhydride and 1,2,7,8-phenanthrenetetracarboxylic acid dianhydride. Particularly preferred tetracarboxylic acid dianhydrides are pyromellitic acid dianhydride, 3,3',4,4'-benzophenonetetracarboxylic acid dianhydride, 3,3',4,4'-bisphenyltetracarboxylic acid dianhydride and bis(3,4-dicarboxyphenyl) ether dianhydride.

Specific examples of the aforesaid diamines are meta-diamines such as 3,3'-diaminobenzophenone, 1,3-bis(3-aminophenoxy)benzene, 4,4'-bis(3-aminophenoxy)biphenyl, 2,2-bis [ 4-(3-aminophenoxy)phenyl] propane, 2,2-bis [ 4-(3-aminophenoxy)phenyl] -1,1,1,3,3,3-hexafluoropropane, bis [ 4-(3-aminophenoxy)phenyl] sulfide, bis [ 4-(3-aminophenoxy) phenyl] ketone and bis [ 4-(-aminophenoxy)phenyl] sulfone. These amines can be used alone or in combination of two or more of them.

The reaction of the foregoing tetracarboxylic acid anhydride with the diamine is generally performed in an organic solvent. Examples of such organic solvents are N-methyl-2-pyrrolidone, N,N-dimethylacetamide, N,N-dimethylformamide, 1,3-dimethyl-2-imidazolidinone, N,N-diethylacetamide, N,N-dimethylmethoxyacetamide, dimethylsulfoxide, pyridine, dimethylsulfone, hexamethylphosphoramide, tetramethyl urea, N-methylcaprolactam, tetrahydrofuran, m-dioxane, p-dioxane, 1,2-dimethoxyethane, bis(2-methoxyethyl) ether, 1,2-bis(2-methoxyethoxy)ethane and bis [2-(2-methoxyethoxy)ethyl] ether.

These organic solvents may be used alone or in combination of two or more of them.

The reaction temperature in general ranges from -20°C to 200°C , preferably -10°C to 50°C and more preferably 0°C to room temperature.

The pressure of the reaction is not restricted to a particular range, but the reaction can be carried out at atmospheric pressure effeciently.

The reaction time varies depending on various factors such as the kinds of solvents used, the reaction temperature selected and the kinds of diamines and acid dianhydrides used. However, it in general takes 2 to 40 hours and preferably 4 to 24 hours to complete the formation of polyamide acid resins.

The solution of the polyamide acid resin thus obtained desirably contains 5 to 40% by weight of the polyamide acid resin and has a logarithmic viscosity ranging from 0.5 to 4 $d\ell$ /g (determined at 35°C, on a 0.5 g/m$\ell$ solution in N,N-dimethylacetamide) from the viewpoint of the water-solubility and film-forming properties of the polyimide obtained after heat-treatment.

In the present invention, an insulating filler may be added to the polyamide acid resin obtained above. Any method for adding such an insulating filler may be employed as long as the insulating filler can be uniformly dispersed in the polyamide acid resin. Examples of such methods are roll kneading and ball milling techniques. The amount of the insulating filler preferably ranges from 2 to 70% by volume on the basis of the total volume of the mixture. If the amount thereof is too small, the intended effect of the filler cannot be attained, while if it is too great, the insulating filler causes precipitation in the final electrophoresis bath.

The insulating fillers usable in the present invention may be either inorganic or organic compounds as long as they have an electric resistivity on the order of not lower than $10^5\ \Omega \cdot cm$. Examples of inorganic compounds used as such insulating fillers are oxides or composite oxides of beryllium, magnesium, calcium, aluminum, boron, silicon, scandium, yttrium, lanthanum, titanium, zirconium, hafnium and rare earth elements; nitrides and oxynitrides of aluminum, boron, silicon, titanium, zirconium, hafnium; and carbides such as silicon carbide. On the other hand, the organic compounds which may be used as such insulating fillers must not be dissolved in the electrophoresis bath and examples of such organic compounds are silicone resins, fluorine plastics represented by Teflons, phenolic resins, furan resins, epoxy resins and acrylic resins.

The insulating fillers may have any shape such as a particulate or fibrous form, but the size thereof is critical and determined as a function of the desired thickness of the resulting insulating layer. More specifically, the maximum diameter of the insulating filler must be smaller than the minimum thickness of the insulating layer. In addition, it is important that the insulating filler be in a well dispersed state in the electrophoresis bath from the industrial point of view. Thus, the average diameter of the insulating filler is not greater than 20μ m and preferably not greater than 10μ m.

In the method of the present invention, the polyamide acid resin having the repeating units represented by the general formula (II) becomes soluble in water because COOH groups thereof dissociate into $COO^-$ ions through the addition of a base such as amines or alkali metal ions in the presence of water or form a stable colloidal dispersion. Therefore, the polyamide acid resin is deposited on inner electrodes (anodes) exposed at the side end faces of a multi-layered element during electrophoresis and is made insoluble in water.

As the foregoing bases, there may be used, for instance, ammonia; secondary amines such as dialkylamines, diethanolamine and morpholine; tertiary amines such as triethylamine, tributylamine, triethanolamine, triisopropanolamine, dimethylethanolamine, dimethylisopropanolamine, diethylethanolamine and dimethylbenzylamine; and inorganic bases such as sodium hydroxide and potassium hydroxide. Particulatly preferred are tertiary amines in view of their stability after diluting with water and properties of the resulting film.

The amount of the base required for the polyamide acid resin to be able to be diluted with water in general ranges from 30 to 110 mole% and preferably 40 to 100 mole% with respect to the carboxyl equivalent of the polyamide acid to be neutralized. Thus, the polyamide acid becomes completely water-soluble or partially soluble in water to form a suspension by such neutralization. Thus, the polyamide acid resin can be diluted with water.

An electrophoresis bath for forming layers can thus be obtained by diluting the neutralized composition with water. Therefore, the bath comprises a suspension containing the polyamide acid resin and optionally an insulating filler.

The coated layer of the polyamide acid resin or a combination of the polyamide acid resin and the insulating filler thus deposited is converted into an insulating layer composed of a polyimide resin having the repeating units represented by the general formula (I):

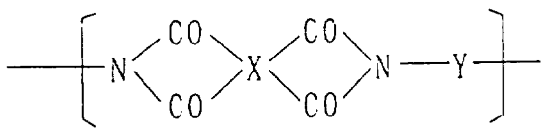

( I )

wherein X is the same as that defined above or a combination of such a polyimide resin and the insulating filler by heat-treating the coated layer at a temperature ranging from 80 to 280°C and preferably 150 to 250°C .

The insulating layer of a polyimide resin or a combination of a polyimide resin and an insulating filler thus prepared is excellent in dielectric strength as well as adhesion to metals.

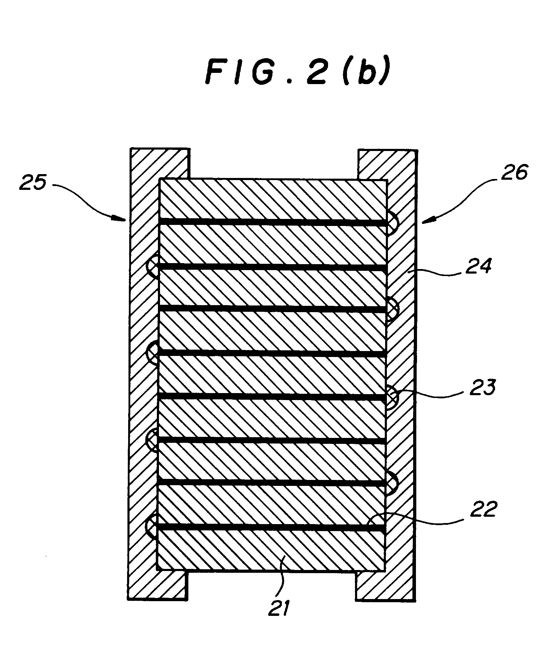

The multi-layered ceramic elements according to the present invention comprises, as illustrated in attached Figs. 2 (a) and 2 (b), a plurality of ceramic films or thin plates and a plurality of inner electrodes which are alternatively arranged in layers. The inner electrodes are present on both upper and lower sides of each ceramic film or thin plate over the whole surface thereof and their ends are exposed at the side end faces of the multi-layered ceramic element. The edge of each inner electrode is connected to either one of positive and negative external electrodes so that every neighbouring two inner electrodes are connected to different external electrodes and then the inner electrodes are insulated by an insulating layer containing the foregoing polyimide resin. Such a multi-layered ceramic element can be directly fitted to a circuit by applying a plating layer of Ni, Sn or the like to the aforementioned external electrodes or indirectly fitted to a circuit by fitting leads to the external electrodes and connecting the leads to the circuit.

In addition, the multi-layered ceramic elements may be optionally sealed with an epoxy resin.

Fig. 2 (a) of the accompanying drawings is a cross sectional perspective view of the multi-layered ceramic condenser according to the present invention. In Fig. 2 (a), the reference numeral 11 represents a dielectric ceramic film or plate, 12 an inner electrode, 13 an insulating layer containing a polyimide resin, 14 a side end face A and 15 a side end face B. In this figure, the external electrodes on both side end faces A and B are omitted.

Fig. 2 (b) of the accompanying drawings is a cross sectional view of the multi-layered ceramic condenser according to the present invention.

In Fig. 2 (b), the reference numeral 21 represents a dielectric ceramic film or plate, 22 an inner electrode, 23 an insulating layer containing a polyimide resin, 24 an external electrode, 25 a side end face A and 26 a side end face B.

The inner electrodes are formed so that every other electrode is exposed at either one of the side end faces A and B and it is insulated by covering it with an insulating layer.

Ceramics used in the multi-layered ceramic elements of the present invention may be any ceramics conventionally

employed in the manufacture of ceramic condensers and electrostrictive/piezoelectric ceramic elements. Specific examples thereof are lead-type perovskite compounds such as (Pb, Ba)(Zr, Ti)$O_3$, Pb(Zn, Nb)$O_3$, Pb(Fe, W)O, Pb(Fe, Nb)$O_3$, Pb(Mg, Nb)$O_3$, Pb(Ni, W)$O_3$, Pb(Mg, W)$O_3$, $PbTiO_3$, Pb(Zr, Ti) $O_3$, Pb(Li, Fe, W)$O_3$ and ($Pb_{1-x}$ $La_x$ )($Zr_y$ $Ti_{1-y}$ )$O_3$; lead-type compounds such as $Pb_5Ge_3O_{11}$; barium-type perovskite compounds such as $BaTiO_3$, Ba(Ti, Sn)$O_3$, (Ba, Sr, Ca)$TiO_3$, (Ba, Ca)(Zr, Ti)$O_3$ and (Ba, Sr, Ca)(Zr, Ti)$O_3$; strontium-type perovskite compounds such as $SrTiO_3$; calcium-type perovskite compounds such as $CaTiO_3$ and $CaZrO_3$; and laminar compounds such as $Bi_4$ $Ti_3$ $O_{12}$. In addition, mixtures thereof can also be employed in the present invention. Besides, natural and/or artificial mica can also be employed as the ceramic thin plate of the present invention.

Examples of materials for the inner electrodes are conductive metal materials such as silver, palladium, gold, platinum, nickel, copper and zinc as well as alloys of these elements.

It is a matter of course that the term "multi-layered bodies" herein used embraces not only those obtained by the so-called green sheet technique but also those obtained by bonding thin plates of sintered materials with adhesives as well as those comprising ceramic thin films and electrodes which are formed according to CVD or PVD methods and are alternatively arranged in layers.

The present invention will be explained in more detail with reference to the following working Examples, but the present invention is not restricted to these specific Examples.

Example 1

53.0 g (0.25 mole) of 3,3'-diaminobenzophenone was dissolved in 240 mℓ of N,N-dimethylacetamide in a reaction vessel provided with a stirrer, a reflux condenser and a tube for introducing nitrogen gas. To this solution, there was added 78.6 g (0.244 mole) of powdered 3,3',4,4'-benzophenonetetracarboxylic acid dianhydride and the mixture was stirred at 10°C for 24 hours to give a solution of a polyamide acid resin. The logarithmic viscosity of the resulting polyamide acid was found to be 0.6 *dℓ* /g. To the polyamide acid solution, there was slowly added 23.9 g (55 mole% with respect to the carboxyl equivalent) of dimethylethanolamine, the mixture was stirred at room temperature for 20 minutes and was diluted with water by gradual addition of 905.3 g of water at room temperature with stirring to thus give an aqueous solution of the polyamide acid (resin concentration = about 10% by weight).

A sample of a multi-layered body was separately produced. The body was comprised of 50 layers arranged in layers, each layer having a thickness of about 50µ m; the ceramic layer having a composition of Pb(Zn, Nb)$O_3$-Pb(Mg, Nb)$O_3$-$BaTiO_3$ type and a dielectric constant of about 9,000; the inner electrodes being mainly composed of silver and palladium. Every other inner electrode was exposed at one side end face of the body while all of the inner electrodes were exposed at the other side end face thereof. A silver electrode was baked on the side end face on which every other inner electrode was exposed and a lead was connected to the silver electrode with solder. The foregoing aqueous solution was introduced into a plastic tank to obtain an electrophoresis bath for forming layers, the multi-layered body to be coated which served as an anode was immersed in the solution and the lead was connected to an anodic power supply. An electric voltage of 60 V was applied for 4 seconds to perform electrophoresis. Thereafter, the multi-layered body was withdrawn from the bath, washed with water and heat-treated at 150 °C for 2 hours and then at 250°C for 3 hours to perform drying and imidation. Then the resulting multi-layered body was cut into two pieces at its center, a silver electrode was applied to the side to which the imide resin-containing insulating film was adhered and a lead was connected thereto with solder. The same procedures were repeated to obtain multi-layered bodies in which each electrode has insulating layers at the both right and left sides. It was confirmed that the thickness of the insulating layer was on the order of 50 µ m and that the dielectric strength thereof was not lower than 500 V.

Example 2

53.0 g (0.25 mole) of 3,3'-diaminobenzophenone was dissolved in 240 mℓ of N,N-dimethylacetamide in a reaction vessel provided with a stirrer, a reflux condenser and a tube for introducing nitrogen gas. To the solution there was added 78.6 g (0.244 mole) of powdered 3,3',4,4'-benzophenonetetracarboxylic acid dianhydride and the mixture was stirred at 10°C for 24 hours to obtain a polyamide acid solution. 620 g of alumina powder (available from Sumitomo Chemical Company, Limited under the trade name of AKP-30) was added to the solution and the mixure was kneaded with a three-roll mill to give an alumina-dispersed polyamide acid varnish. 21.7 g (50 mole% with respect to the carboxyl equivalent) of dimethylethanolamine was slowly added to the varnish, the resulting mixture was stirred at room temperature for 20 minutes and diluted with water by gradual addition of 905.3 g of water with stirring at room temperature to thus obtain a suspension of polyamide acid resin containing alumina powder.

The same sample of the multi-layered body used in Example 1 was employed, a silver electrode was baked on the side at which every other metal electrode was exposed and a lead was connected thereto with solder. The suspension prepared above was introduced into a plastic tank to obtain an electrophoresis bath for forming films, the multi-layered body to be coated which served as an anode was immersed in the solution and the lead was connected to an anodic

power supply. An electric voltage of 20 V was applied for 5 seconds to perform electrophoresis. Thereafter, the multi-layered body was withdrawn from the bath, washed with an aqueous solution containing 20% by weight of N,N-dimethylacetamide and heat-treated at 150°C for 2 hours and then at 250°C for 3 hours to perform drying and imidation. Then the resulting multi-layered body was cut into two pieces at its center, a silver electrode was applied to the side to which the imide resin-containing insulating film was adhered and a lead was connected thereto with solder. The same procedures were repeated to obtain multi-layered bodies in which each electrode has insulating layers at both the right and left sides. It was confirmed that the thickness of the insulating layer was on the order of 50μ m.

The dielectric strength of the multi-layered body thus obtained was determined and found to be not lower than 500V.

Example 3

To a reaction vessel equipped with a stirrer, a reflux condenser and a tube for introducing nitrogen gas, there were introduced 41.0 g (0.1 mole) of 2,2-bis [ 4-(3-aminophenoxy)phenyl] propane and 200 mℓ of N,N-dimethylacetamide, the contents of the vessel were cooled down to around 0°C , 21.8 g (0.1 mole) of powdered pyromellitic acid dianhydride was added to the contents of the vessel under a nitrogen gas atmosphere and the mixture was stirred at a temperature of around 0°C for 2 hours. Then the temperature of the solution was brought back to room temperature and it was stirred for about 20 hours under a nitrogen gas atmosphere. The logarithmic viscosity of the resulting polyamide acid was found to be 1.5 dℓ /g. To the polyamide acid solution, 20.2 g (100 mole% with respect to the carboxyl equivalent) of triethylamine was slowly added, the mixture was stirred at room temperature for one hour and diluted with water by gradual addition of 973 g of water with stirring to thus obtain an aqueous solution of polyamide acid resin (resin concentration = about 5% by weight).

As in the same manner used in Example 1, a sample of the multi-layered body was prepared, an insulating layer was formed on the sample using the polyamide acid resin solution prepared above. It was found that the thickness of the resulting insulating layer was 50μ m and that the dielectric strength thereof was not lower than 500 V.

Example 4

To a vessel provided with a stirrer, a reflux condenser and a tube for introducing nitrogen gas, there were added 41.0 g (0.1 mole) of 2,2-bis [ 4-(3-aminophenoxy)phenyl] propane and 219.6 g of N,N-dimethylacetamide, 31.6 g (0.098 mole) of 3,3',4,4'-benzophenonetetracarboxylic acid dianhydride in the form of dried solid as such was added, in small portions, to the contents of the vessel at room temperature under a nitrogen gas atmosphere while care was taken not to increase the temperature of the solution and the mixture was stirred at room temperature for 23 hours. The logarithmic viscosity of the resulting polyamide acid solution was found to be 0.70 dℓ /g. To the polyamide acid solution, 14.6 g (50 mole% with respect to the carboxyl equivalent) of triethanolamine was slowly added, the mixture was stirred at 40°C for 2 hours and diluted with water by gradual addition of 117.2 g of water with stirring to thus obtain an aqueous solution of polyamide acid resin (resin concentration = about 15% by weight).

As in the same manner used in Example 1, a sample of the multi-layered body was prepared, an insulating layer was formed on the sample using the polyamide acid resin solution prepared above. It was found that the thickness of the resulting insulating layer was 50μ m and that the dielectric strength thereof was not lower than 500 V.

Example 5

The same procedures used in Example 2 were repeated to form a multi-layered ceramic element except that silica powder (average particle size = 0.5μ m) was substituted for the alumina powder used in Example 2. The dielectric breakdown voltage of the resulting sample was found to be not lower than 500 V.

Example 6

The same procedures used in Example 2 were repeated to form a multi-layered ceramic element except that silicon nitride powder (average particle size = 0.8μ m) was substituted for the alumina powder used in Example 2. The dielectric breakdown voltage of the resulting sample was found to be not lower than 500 V.

Example 7

The same procedures used in Example 2 were repeated to form a multi-layered ceramic element except that titania powder (average particle size = 0.8 μ m) was substituted for the alumina powder used in Example 2. The dielectric breakdown voltage of the resulting sample was found to be not lower than 500 V.

Example 8

The same procedures used in Example 2 were repeated to form a multi-layered ceramic element in which the ceramic layer had a composition of (Pb,Ba)(Zr,Ti)$O_3$-$La_2O_3$ type. The element showed a piezoelectricity. The dielectric breakdown voltage of the element was found to be not lower than 500 V. And the strain of the element at 10 kV/cm was found to be nearly equal to that of a mono-layer element.

Example 9

The same procedures used in Example 2 were repeated to form a multi-layered ceramic element in which the ceramic layer had a composition of (Pb,Ba)(Zr,Ti)$O_3$-$Nd_2O_3$ type. The element showed an electrostricity. The dielectric breakdown voltage of the element was found to be not lower than 500 V. And the strain of the element at 10 kV/cm was found to be nearly equal to that of a mono-layer element.

As seen from the results of the foregoing Examples, the multi-layered ceramic elements of the present invention have high dielectric strength and can be produced by a simple method at a high efficiency as compared with those produced by conventional methods. Thus, multi-layered ceramic elements exhibiting high reliability can be produced at a low cost according to the present invention.

## Claims

1. A method for producing a multi-layered ceramic element which comprises the steps of immersing a ceramic multi-layered body, which comprises a plurality of ceramic films or plates and a plurality of inner electrodes which are alternatively arranged in layers with the ends of the inner electrodes being exposed at side end faces of the multi-layered body, in an electrophoresis bath for forming a deposit which is obtained by neutralizing, with a base, carboxyl groups of a polyamide acid resin having repeating units represented by the following general formula:

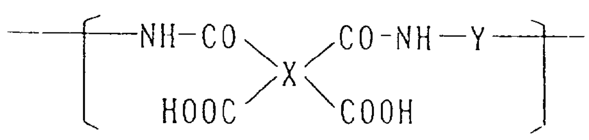

in which X represents a tetravalent phenyl group, a tetravalent biphenyl group, or a tetravalent polyphenyl and polybiphenyl group in which at least one of either the phenyl group or biphenyl group is bonded through at least one of O, CO, S, $SO_2$, $CH_2$, $C(CH_3)_2$ and $C(CF_3)_2$, and Y represents a phenylene group, biphenylene group, a bivalent polyphenyl and polybiphenyl group in which at least one of either the phenyl group or biphenyl group is bonded through at least one of O, CO, S, $SO_2$, $CH_2$, $C(CH_3)_2$ and $C(CF_3)_2$, an alkylene group or a xylylene group, and then diluting the resin with water, carrying out electrophoresis by passing an electric current through only alternate inner electrodes of the ceramic multi-layered body which serve as anodes to deposit the polyamide acid resin on only the exposed portions of the said alternate inner electrodes and the ceramic surface in the vicinity of the exposed portions of those electrodes and to thus form a deposit, heat-treating the resulting assembly at a temperature from 80 to 280°C to convert the polyamide acid resin into its imide form to thus form an insulating deposit comprising a polyimide resin represented by the following general formula:

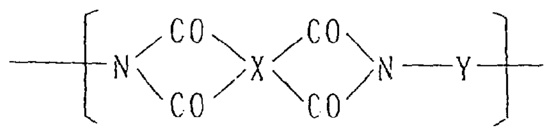

in which X and Y are as defined above, cutting the resulting assembly,
and subjecting the other of the said alternate inner electrodes to the electrophoresis and heat treating as defined above.

2. A method as claimed in Claim 1 in which the multi-layered ceramic element is a multi-layered electrostrictive/piezoelectric ceramic element.

3. A method as claimed in Claim 2 in which the multi-layered ceramic element is a multi-layered ceramic condenser element.

4. A method as claimed in any preceding claim in which the electrophoresis bath comprises the said polyamide acid resin and an insulating filler dispersed therein, so forming an insulating deposit comprising the said polyimide resin and the insulating filler.

**Patentansprüche**

1. Verfahren zur Herstellung eines mehrschichtigen Keramikelements, umfassend die Schritte Eintauchen eines keramischen mehrschichtigen Körpers, der eine Vielzahl von keramischen Filmen oder Platten und eine Vielzahl von Innenelektroden aufweist, die abwechselnd in Schichten angeordnet sind, wobei die Enden der Innenelektroden an den Seitenstirnflächen des mehrschichtigen Körpers freiliegen, in ein Elektrophoresebad zur Herstellung einer Abscheidung, die erhalten wird durch Neutralisieren mit einer Base, Carboxylgruppen eines Polyamidsäureharzes, das die wiederkehrenden Einheiten, wiedergegeben durch die nachstehende allgemeine Formel, aufweist:

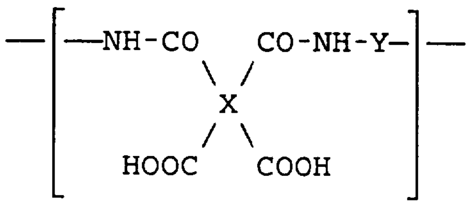

worin X eine vierwertige Phenylgruppe, eine vierwertige Biphenylgruppe oder eine vierwertige Polyphenyl- und Polybiphenylgruppe darstellt, worin mindestens eine der entweder Phenylgruppe oder Biphenylgruppe durch mindestens einen von O, CO, S, $SO_2$, $CH_2$, $C(CH_3)_2$ und $C(CF_3)_2$ gebunden ist, und Y eine Phenylengruppe, eine Biphenylengruppe, eine zweiwertige Polyphenyl- und Polybiphenylgruppe wiedergibt, worin mindestens eine der entweder Phenylgruppe oder Biphenylgruppe durch mindestens einen von O, CO, S, $SO_2$, $CH_2$, $C(CH_3)_2$ und $C(CF_3)_2$, einer Alkylengruppe oder einer Xylylengruppe gebunden ist, und anschließend Verdünnen des Harzes mit Wasser, Ausführen von Elektrophorese durch Leiten eines elektrischen Stroms durch lediglich alternierende Innenelektroden des keramischen mehrschichtigen Körpers, die als Anoden zur Abscheidung des Polyamidsäureharzes auf nur den freiliegenden Teilen der alternierenden Innenelektroden und der Keramikoberfläche in der Nähe der freiliegenden Teile dieser Elektroden dienen und somit Bilden einer Abscheidung, Wärmebehandlung der entstandenen Anordnung bei einer Temperatur von 80 bis 280°C, um das Polyamidsäureharz in seine Imidform umzuwandeln und so eine isolierende Abscheidung, die ein Polyimidharz, wiedergegeben durch die nachstehende allgemeine Formel, umfaßt,

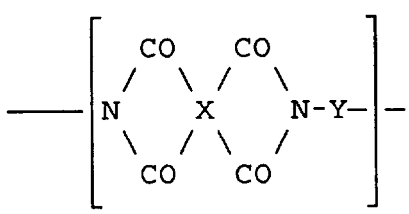

worin X und Y wie vorstehend definiert sind, zu bilden, Schneiden der erhaltenen Anordnung und Elektrophorese und Wärmebehandlung der anderen alternierenden Innenelektroden, wie vorstehend beschrieben.

2. Verfahren nach Anspruch 1, wobei das mehrschichtige keramische Element ein mehrschichtiges elektrostriktives/piezoelektrisches keramisches Element ist.

3. Verfahren nach Anspruch 2, wobei das mehrschichtige keramische Element ein mehrschichtiges keramisches Kondensatorelement ist.

4. Verfahren nach einem vorangehenden Anspruch, wobei das Elektrophoresebad das Polyamidsäureharz und einen isolierenden Füllstoff darin dispergiert umfaßt, so daß eine isolierende Abscheidung, die das Polyimidharz und den isolierenden Füllstoff umfaßt, gebildet wird.

**Revendications**

1. Procédé de production d'un élément en céramique multicouche qui comprend les étapes selon lesquelles on immerge un corps multicouche en céramique comprenant une pluralité de films ou plaques en céramique et une pluralité d'électrodes internes disposées en couches alternées, les extrémités des électrodes internes étant exposées au niveau de la surface des extrémités latérales du corps multicouche, dans un bain d'électrophorèse destiné à la formation d'un dépôt et qui est obtenu par neutralisation avec une base des groupes carboxyle d'une résine poly(amide acide) ayant des unités constitutives représentées par la formule générale suivante:

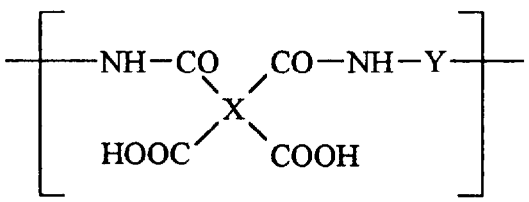

dans laquelle X représente un groupe phényle tétravalent, un groupe biphényle tétravalent ou un groupe polyphényle et polybiphényle tétravalent dans lequel au moins l'un des groupes phényle ou biphényle est lié par l'intermédiaire d'au moins un groupe choisi parmi O, CO, S, $SO_2$, $CH_2$, $C(CH_3)_2$ et $C(CF_3)_2$, et Y représente un groupe phénylène, un groupe biphénylène, un groupe polyphényle et polybiphényle divalent dans lequel au moins un des groupes phényle ou biphényle est lié par l'intermédiaire d'au moins un groupe choisi parmi O, CO, S, $SO_2$, $CH_2$, $C(CH_3)_2$ et $C(CF_3)_2$, un groupe alkylène ou un groupe xylylène, puis dilution de la résine avec de l'eau,
on effectue l'électrophorèse en faisant passer un courant électrique seulement à travers les électrodes internes alternées servant d'anodes dans le corps en céramique multicouche pour ne déposer la résine poly(amide acide) que sur les portions exposées desdites électrodes internes alternées et sur la surface de céramique voisine des portions exposées de ces électrodes et pour y former ainsi un dépôt, on fait subir un traitement thermique à l'assemblage obtenu à une température de 80 à 280°C pour transformer la résine poly(amide acide) en sa forme imide afin de former un dépôt isolant comprenant une résine polyimide représentée par la formule générale suivante

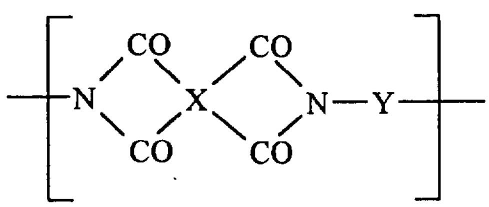

dans laquelle X et Y ont la définition donnée ci-dessus,
on coupe l'assemblage obtenu et on soumet la seconde desdites électrodes internes alternées à l'électrophorèse et au traitement thermique de la façon définie ci-dessus.

2. Procédé selon la revendication 1, dans lequel l'élément en céramique multicouche est un élément en céramique multicouche piézo-électrique à effet d'électrostriction.

3. Procédé selon la revendication 2, dans lequel l'élément en céramique multicouche est un élément condensateur en céramique multicouche.

4. Procédé selon l'une quelconque des revendications précédentes, dans lequel le bain d'électrophorèse contient ladite résine poly(amide acide) et une charge isolante qui y est dispersée, de façon à former un dépôt isolant comprenant ladite résine polyimide et la charge isolante.

FIG. 1

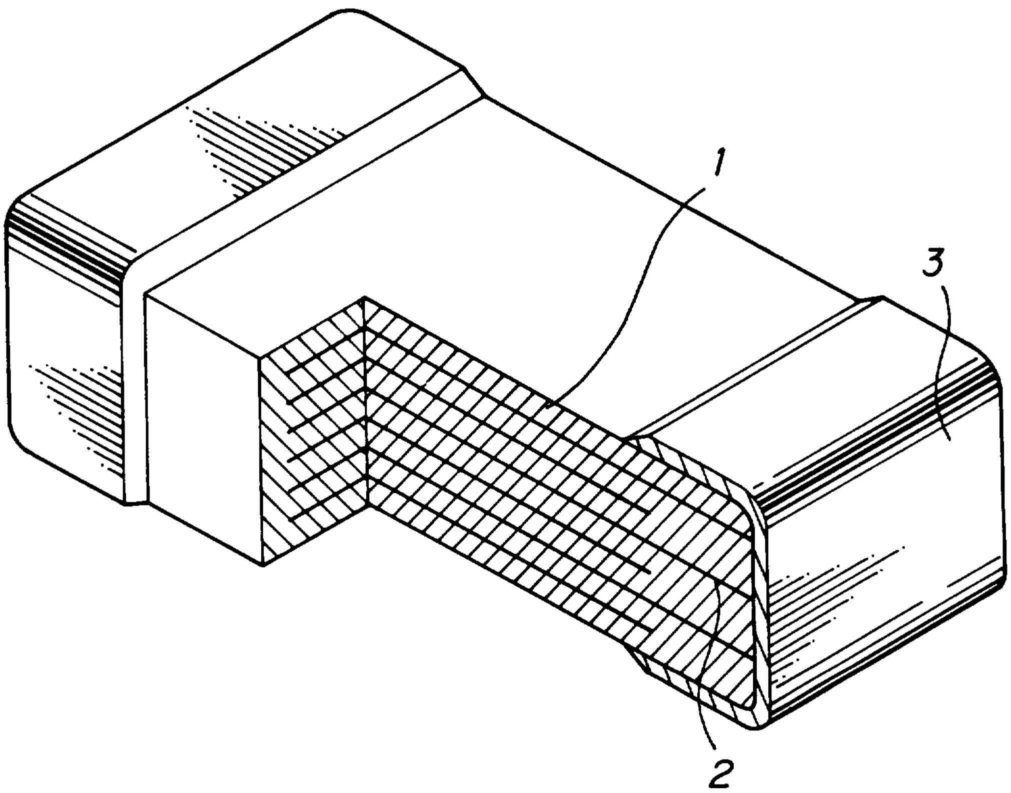

FIG. 2(a)

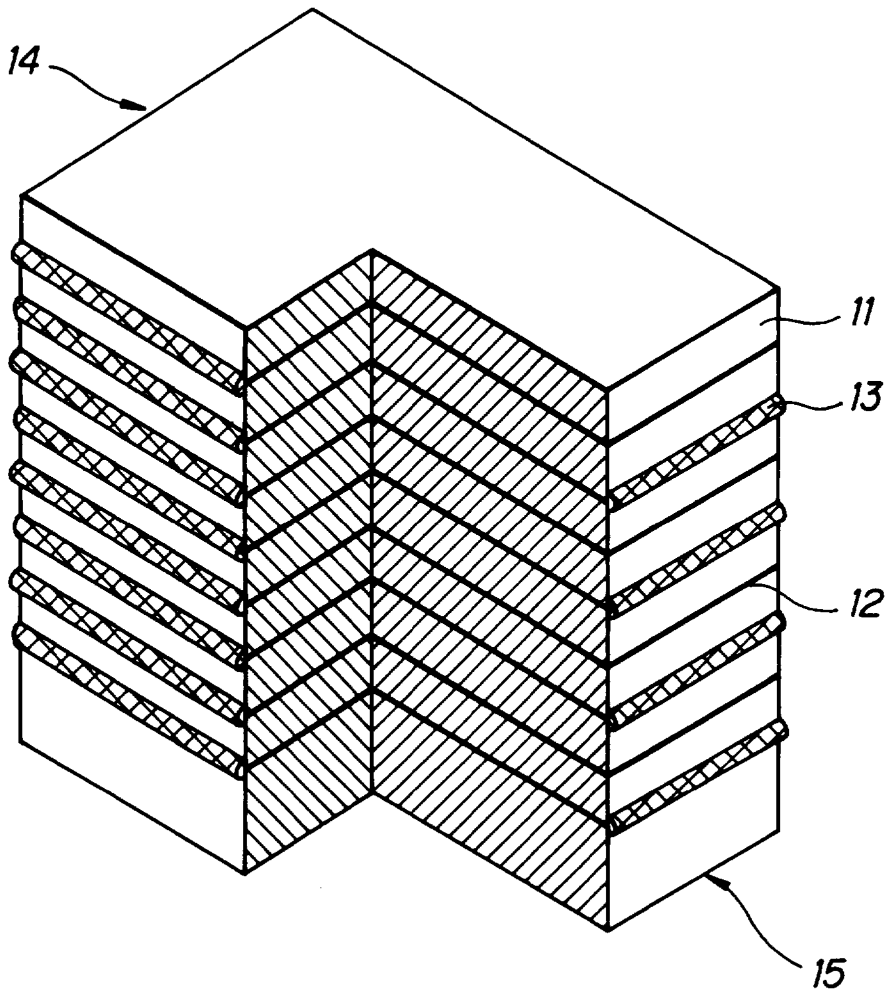

FIG. 2 (b)